# EUROPÄISCHE PATENTSCHRIFT

(11) **EP 2 068 156 B1**
(45) Veröffentlichungstag und Bekanntmachung des Hinweises auf die Patenterteilung: **30.05.2018**
(21) Anmeldenummer: 08018482.3
(22) Anmeldetag: 22.10.2008
(51) Int. Cl.: G01R 1/067

(54) **Tastkopf mit Wellenleiter mit konzentrierter Dämpfung**
Probe head with waveguide with concentrated damping
Tête de sonde dotée d'un guide d'ondes ayant une atténuation concentrée

(30) Priorität: 04.12.2007 DE 102007058205; 20.02.2008 DE 102008009961
(43) Veröffentlichungstag der Anmeldung: 10.06.2009
(73) Patentinhaber: Rohde & Schwarz GmbH & Co. KG, 81671 München (DE)
(72) Erfinder: Peschke, Martin, Dr., 81549 München (DE)
(74) Vertreter: Körfer, Thomas

(56) Entgegenhaltungen:
- EP-A2- 1 605 588
- DE-A1- 10 157 678
- JP-A- H11 258 273
- US-A- 4 418 314
- US-A- 5 107 201
- US-A- 5 502 372
- US-A1- 2006 290 357
- US-B1- 7 042 232

## Beschreibung

Die Erfindung betrifft einen Tastkopf mit einem Wellenleiter mit konzentrierter, insbesondere inhomogener Dämpfung.

Um in der Messtechnik Spannungen hochohmig und breitbandig abzugreifen werden zumeist aktive Tastköpfe verwendet. Es gibt sie in massebezogener oder differenzieller Ausführung. Neben einem Pufferverstärker verfügen sie zumeist auch über ein Teilernetzwerk, um den aktiven Spannungsbereich zu erweitern und die Eingangskapazität zu minimieren. Je größer die Bandbreite solcher Tastköpfe jedoch wird, umso kompakter müssen Teilernetzwerk und Tastspitze sein, um Ausbreitungseffekte elektromagnetischer Wellen gering zu halten. So würde beispielsweise eine hochohmig abgeschlossene, 1,5 cm lange Tastspitze in Luft bereits bei einer Frequenz von 5 GHz durch Impedanztransformation einen Kurzschluss in der Messebene bewirken und damit das zu messende Signal zerstören. Diese Eigenschaft breitbandiger Tastspitzen steht im direkten Widerspruch zu einer komfortablen und flexiblen Adaption am Messpunkt, da Messpunkte häufig schwer zugänglich und mit kurzen Tastspitzen nicht zu erreichen sind. Um diesen Widerspruch zu vermeiden, werden seit kurzem aktive Tastköpfe mit Teilernetzwerken vorgestellt, die einen Wellenleiter als Verlängerungskabel enthalten. Üblicherweise werden Koaxialleitungen als Wellenleiter eingesetzt.

Die große Herausforderung beim Design eines solchen Tastkopfes mit Wellenleiter besteht nun darin, einen möglichst glatten Frequenzgang zu erhalten. Da die gesamte Anordnung bei Gleichspannung hochohmig abgeschlossen sein soll, das Kabel aber bei der oberen Messfrequenz oft mehrere Wellenlängen lang ist, sind aufwändige Kompensationsmaßnahmen unbedingt notwendig. Bei dem Einsatz verlustfreier Wellenleiter ergibt sich jedoch trotz optimal gewählter übriger Komponenten eine starke verbleibende Welligkeit der Übertragungsfunktion des Tastkopfes. Ein Einsatz von gedämpften Wellenleitern reduziert zwar die Welligkeit, aber eine Fertigung von Koaxialleitungen mit einer starken homogenen Dämpfung ist nicht aufwandsarm realisierbar.

So wird in der Europäischen Patentanmeldung EP-A 1 605 588 ein Tastkopf mit gedämpftem Wellenleiter gezeigt. Der Wellenleiter ist dabei als Koaxialleitung ausgeführt. Die Dämpfung ist dort durch einen Innenleiter der Koaxialleitung mit ohmschem Widerstandsbelag realisiert. Die dort gezeigte Lösung ist jedoch nachteilhaft, da eine deutliche Restwelligkeit verbleibt. Weiterhin ist die Fertigung von Koaxialleitungen mit Innenleitern mit ohmschem Widerstandsbelag aufwändig. Der maximale Widerstandsbelag in koaxiler Ausführung ist auf ca. 1000Ohm/m begrenzt. Der Wellenwiderstand der Koaxialleitung kann nicht beliebig eingestellt werden.

Das Dokument US 4,418,314 offenbart eine Messspitze zur hochohmigen Spannungsmessung. Die Messspitze beinhaltet eine Serienschaltung einer Vielzahl von Parallelschaltungen jeweils eines ohmschen Widerstands und eines Kondensators.

Der Erfindung liegt die Aufgabe zu Grunde, einen Tastkopf zu schaffen, welcher beliebige Signale aufnimmt und verlustarm, einkopplungsarm und unverzerrt an ein Messgerät weiterleitet. Insbesondere eine geringe Welligkeit der Übertragungsfunktion und eine niedrige Eingangskapazität und ein hoher Eingangswiderstand werden dabei angestrebt.

Die Aufgabe wird erfindungsgemäß für die Vorrichtung durch die Merkmale des unabhängigen Anspruchs 1 gelöst. Vorteilhafte Weiterbildungen sind Gegenstand der hierauf rückbezogenen Unteransprüche.

Der erfindungsgemäße Tastkopf beinhaltet zumindest einen Wellenleiter, welcher zumindest einen Streifenleiter beinhaltet. Der zumindest eine Streifenleiter beinhaltet mehrere konzentrierte ohmsche Widerstände, welche in festgelegten Abständen über die Länge des Streifenleiters verteilt sind. So ist eine Verlängerung des Tastkopfes bei geringer Welligkeit der Übertragungsfunktion und günstigem Wellenwiderstand gegeben. Aufwändige Koaxialkabel können so vermieden werden.

Vorteilhafterweise stellen die Größe und Verteilung der konzentrierten ohmschen Widerstände auf dem zumindest einen Streifenleiter die Übertragungsfunktion des Wellenleiters ein.

Der Tastkopf beinhaltet vorzugsweise zumindest ein passives Teilerelement. Damit ist die Messung von Signalen unterschiedlicher Spannungen möglich, ohne die Hochfrequenzeigenschaften des Tastkopfes zu verschlechtern.

Der Tastkopf beinhaltet bevorzugt zumindest einen Pufferverstärker. So ist eine Vorverstärkung des Signals vor Eingang in ein Messgerät möglich. Dies reduziert die Anforderungen an das Messgerät und verbessert die Qualität des gemessenen Signals.

Vorteilhafterweise sind die mehreren konzentrierten ohmschen Widerstände durch Strukturierung des Streifenleiters gebildet. So ist eine einfache Fertigung der Widerstände gegeben. Übergangsstellen, welche Störungen verursachen, werden so vermieden.

Bevorzugt sind die mehreren konzentrierten ohmschen Widerstände als SMD Widerstände oder als eingebettete Widerstände realisiert. So kann auf sehr verfügbare Standardbauteile zur Realisierung zugegriffen werden.

Der zumindest eine Streifenleiter ist bevorzugt als eine metallisierte Schicht auf einem Substrat ausgebildet. Dies erlaubt eine einfache Fertigung bei großer Flexibilität des Einsatzes.

Vorteilhafterweise ist zwischen dem Substrat und der metallisierten Schicht eine leitfähige Schicht aufgebracht, welche einen höheren ohmschen Widerstand aufweist. Die mehreren konzentrierten ohmschen Widerstände sind bevorzugt durch zumindest eine Aussparung der metallisierten Schicht gebildet. So ist eine Strukturierung der metallisierten Schicht einfach möglich. Das Verbleiben der leitfähigen Schicht unterhalb der Aussparung ist eine sehr einfache Möglichkeit, beliebige Widerstände lokal konzentriert zu fertigen.

Vorteilhafterweise ist die zumindest eine Aussparungen der metallisierten Schicht über die gesamte Breite des Streifenleiters ausgebildet. Die Länge der zumindest einen Aussparung der metallisierten Schicht bestimmt bevorzugt die Größe der konzentrierten ohmschen Widerstände. Auf Grund der geringen Breite des Streifenleiters gegenüber seiner Länge sind so sehr geringe Toleranzen der Widerstandsgröße zu erreichen. Eine Längenabweichung der Aussparung wirkt sich nur gering auf den Widerstand aus.

Die zumindest eine Aussparung der metallisierten Schicht ist bevorzugt durch einen Ätzvorgang erzeugt. So ist die Fertigung der Aussparungen mit derselben Technologie wie die Fertigung des Streifenleiters gewährleistet.

Die metallisierte Schicht besteht bevorzugt aus Gold oder Kupfer. Ein sehr hoher Leitwert bei sehr hoher Genauigkeit der Fertigung und Korrosionsbeständigkeit wird so erreicht.

Die leitfähige Schicht besteht bevorzugt aus einer NickelChrom-Legierung. Ein sehr genau einstellbarer Widerstandsbelag wird so erreicht. Weiterhin ist die Fertigung einfach und das Material günstig verfügbar. Der Widerstandsbelag ist außerdem nur wenig von der Temperatur abhängig.

Auf der Rückseite des Substrats ist bevorzugt eine metallisierte Lage als Masse aufgebracht. So werden störende Einkopplungen verringert.

Auf der Vorderseite des Substrats sind bevorzugt metallisierte Streifen als Masse aufgebracht. So werden störende Einkopplungen verringert während gleichzeitig der Aufwand der Metallisierung der Substratrückseite vermieden wird. Außerdem bleibt so der kapazitive Belag der Leitung gering.

Bevorzugt beinhaltet der Tastkopf zumindest zwei Streifenleiter, welche jeweils mehrere konzentrierte ohmsche Widerstände beinhalten. Die konzentrierten ohmschen Widerstände sind bevorzugt symmetrisch auf den beiden Streifenleitern angeordnet. Die jeweils symmetrischen ohmschen Widerstände auf den beiden Streifenleitern weisen bevorzugt die gleiche Größe auf. Dies sorgt für eine störungsfreie Übertragung des Signals an das Messgerät. Verzerrungen durch asymmetrische Verteilung der Widerstände und ungleiche Größen treten nicht auf.

Der Tastkopf beinhaltet bevorzugt zumindest zwei Streifenleiter, welche zumindest eine Überkreuzung aufweisen. Gegentakteinkopplungen können kompensiert werden, da sie in jedem Abschnitt zwischen Überkreuzungen mit wechselndem Vorzeichen eingehen.

Die mehreren konzentrierten ohmschen Widerstände können gleichmäßig über die Länge des zumindest einen Streifenleiters verteilt sein. Eine einfache Fertigung bei hinreichend geringer Welligkeit der Übertragungsfunktion ist so gegeben.
Alternativ sind die mehreren konzentrierten ohmschen Widerstände ungleichmäßig über die Länge des zumindest einen Streifenleiters verteilt. Eine hochgenaue Einstellbarkeit des Wellenwiderstandes und eine extrem geringe Welligkeit der Übertragungsfunktion kann so erreicht werden.

Die mehreren konzentrierten ohmschen Widerstände können dieselbe Größe aufweisen. Eine sehr einfache Fertigung ist so gewährleistet.

Vorteilhafterweise weisen die mehreren konzentrierten ohmschen Widerstände unterschiedliche Größen auf. Eine sehr genaue Einstellbarkeit des Wellenwiderstandes und eine sehr geringe Welligkeit der Übertragungsfunktion kann so erreicht werden.

Vorteilhafterweise liegt der Widerstandswert der mehreren konzentrierten ohmschem Widerstände im Bereich von 1 Ohm bis 100 Ohm, bevorzugt im Bereich von 10 Ohm bis 50 Ohm, besonders bevorzugt im Bereich von 25 Ohm bis 35 Ohm. Vorteilhafterweise liegt der Abstand zwischen den mehreren konzentrierten ohmschen Widerständen auf dem Streifenleiter unterhalb von 20 mm, bevorzugt unterhalb von 10 mm, besonders bevorzugt unterhalb von 5 mm. So wird eine optimal geringe Restwelligkeit der Übertragungsfunktion erreicht.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein Blockdiagramm eines ersten Ausführungsbeispiels des erfindungsgemäßen Tastkopfes;
- Fig. 2: ein Ersatzschaltbild eines ersten beispielhaften Wellenleiters;
- Fig. 3a: den Aufbau eines ersten Ausführungsbeispiels des erfindungsgemäßen Wellenleiters;
- Fig. 3b: den Aufbau einer zweiten Ausgestaltung des ersten Ausführungsbeispiels des erfindungsgemäßen Wellenleiters;
- Fig. 4: den Aufbau eines zweiten Ausführungsbeispiels des erfindungsgemäßen Wellenleiters;
- Fig. 5: eine tabellarische Übersicht der Parameter mehrerer verschiedener beispielhafter Tastköpfe;
- Fig. 6: eine erste Übertragungsfunktion eines bisher üblichen beispielhaften Wellenleiters;
- Fig. 7: eine Übertragungsfunktion eines Ausführungsbeispiels des erfindungsgemäßen Wellenleiters;
- Fig. 8: eine Übertragungsfunktion eines weiteren Ausführungsbeispiels des erfindungsgemäßen Wellenleiters;
- Fig. 9: ein Blockdiagramm eines zweiten Ausführungsbeispiels des erfindungsgemäßen Tastkopfes;
- Fig. 10: ein Ersatzschaltbild eines dritten Ausführungsbeispiels des erfindungsgemäßen Wellenleiters.

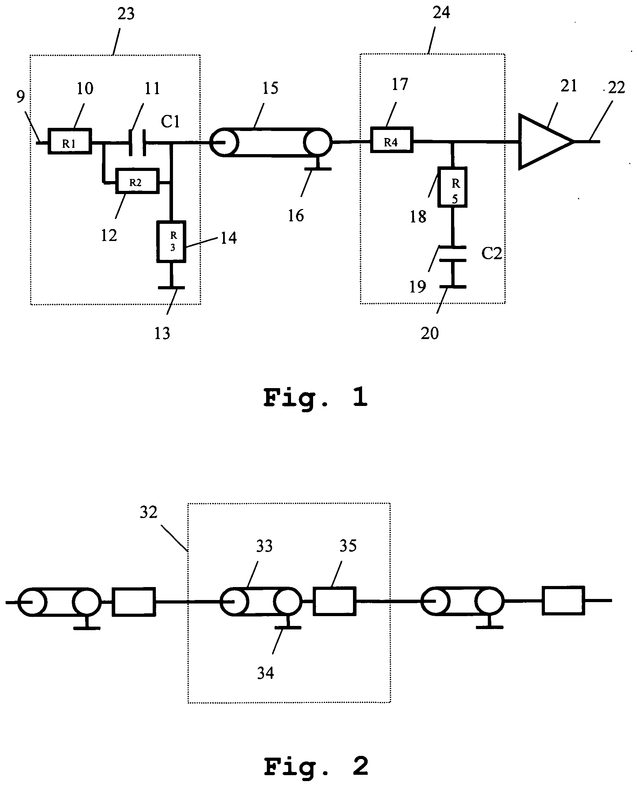

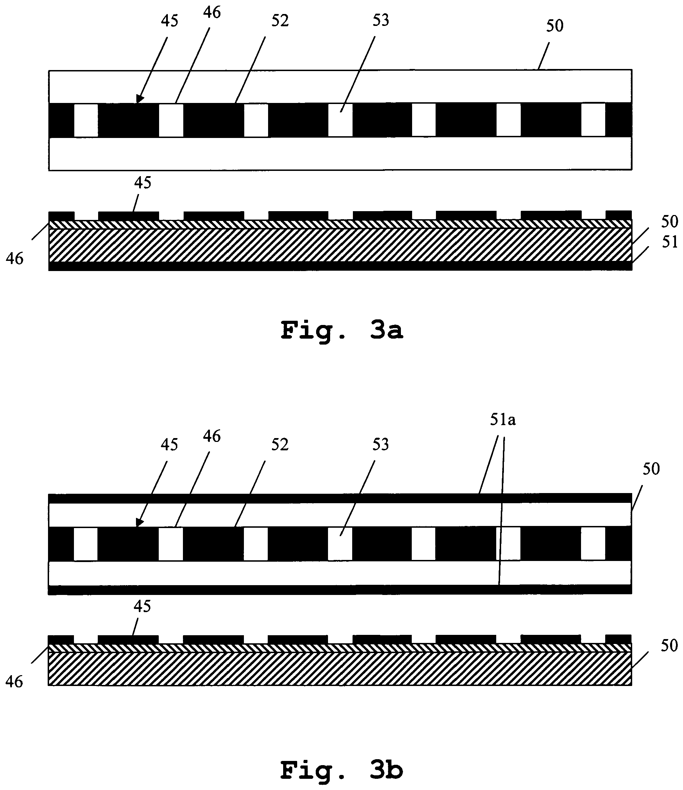

Zunächst wird anhand der Fig. 1 und 2 der Aufbau und die Funktionsweise von herkömmlichen Tastköpfen gezeigt und in die Funktion des erfindungsgemäßen Tastkopfes eingeführt. Anhand der Fig. 3 - 11 wird der Aufbau und die Funktionsweise verschiedener Ausführungsbeispiele des erfindungsgemäßen Tastkopfes erläutert. Identische Elemente wurden in ähnlichen Abbildungen zum Teil nicht wiederholt dargestellt und beschrieben.

Fig. 1 zeigt ein Blockdiagramm eines ersten Ausführungsbeispiels des erfindungsgemäßen Tastkopfes. Gezeigt wird ein beispielhaftes Teilernetzwerk mit passiven Teilerelementen 23, 24, einem Wellenleiter 15 und einem Pufferverstärker 21. Dabei bilden die Widerstände 10, 12, 14, 17 und 18 gemeinsam mit den Kapazitäten 11 und 19 passive Teilerelemente 23, 24. Der Wellenleiter 15 ist mit einer Schirmung versehen, welche mit einem Masseanschluss 16 verbunden ist. Die passiven Teilerelemente 23, 24 sind ebenfalls mit Masseanschlüssen 13 und 20 verbunden. Der Widerstand 17 dient als Serienwiderstand. An dem Messpunkt wird das Signal von dem Tastspitzenanschluss 9 aufgenommen. Das übermittelte und verstärkte Signal wird über den Messgeräteanschluss 22 an das Messgerät übertragen. Ist der hier eingesetzte Wellenleiter 15 ein konventioneller Wellenleiter, z.B. eine Koaxialleitung, so handelt es sich um einen herkömmlichen Tastkopf. Handelt es sich bei dem Wellenleiter um einen erfindungsgemäßen Wellenleiter handelt es sich um einen erfindungsgemäßen Tastkopf.

Fig. 2 zeigt ein Ersatzschaltbild eines ersten beispielhaften Wellenleiters. Ein Abschnitt 32 des Wellenleiters wird dabei als Serienschaltung eines idealen Wellenleiters 33 und eines ohmschen Serienwiderstandes 35 modelliert. Ein infinitesimales Stück des Wellenleiters wird durch eine Serieninduktivität und eine Parallelkapazität nach Masse modelliert. Der Wellenleiter ist aus einer beliebigen Anzahl solcher Abschnitte zusammengesetzt. Bei einem völlig ungedämpften Wellenleiter ist der Serienwiderstand gleich Null. Bei dem Wellenleiter, welcher in dem erfindungsgemäßen Tastkopf eingesetzt wird, sind die ohmschen Serienwiderstände als diskrete Bauteile realisiert. Damit erstrecken sie sich nur über eine sehr kurze Distanz des Wellenleiters.

In Fig. 3a wird der Aufbau eines ersten Ausführungsbeispiels des erfindungsgemäßen Wellenleiters dargestellt. Ein Streifen 46 aus Widerstandsmaterial ist auf einem Substrat 50 aufgebracht. Das Substrat 50 verfügt rückseitig über eine Metallisierung 51, die als Masse dient. Auf dem Streifen 46 aus Widerstandsmaterial ist eine Metallisierung 52 für den Streifenleiter 45 aufgebracht. Durch Aussparungen 53 in der Metallisierung 52 sind diskrete ohmsche Widerstände realisiert. In der Zeichnung sind der besseren Übersichtlichkeit halber die Längen der Aussparungen gegenüber den Längen der Streifenleiter stark übertrieben dargestellt. Die Aussparungen 53 sind in diesem Ausführungsbeispiel über die Länge des Streifenleiters 45 gleichmäßig verteilt und verfügen über identische Länge.

In Fig. 3b ist die metallisierte rückseitige Massefläche 51 aus Fig. 3a durch vorderseitig angebrachte metallisierte Massestreifen 51a ersetzt. Diese Lösung reduziert parasitäre Kapazitäten gegenüber Masse.

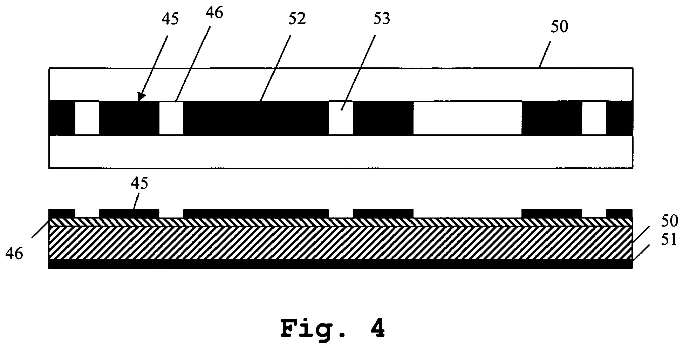

Fig. 4 zeigt den Aufbau eines zweiten Ausführungsbeispiels des erfindungsgemäßen Wellenleiters. Die Aussparungen 53 der Metallisierung 52 des Streifenleiters 45 sind hier ungleichmäßig über der Länge des Streifenleiters 45 verteilt. Außerdem verfügen die Aussparungen 53 nicht über dieselbe Länge.

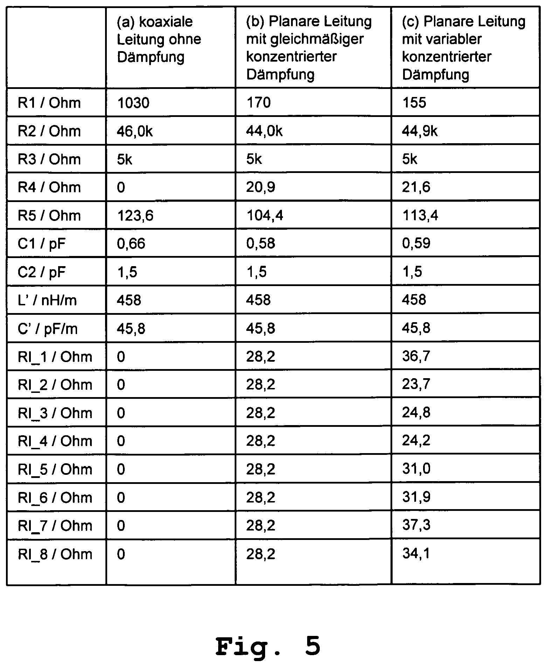

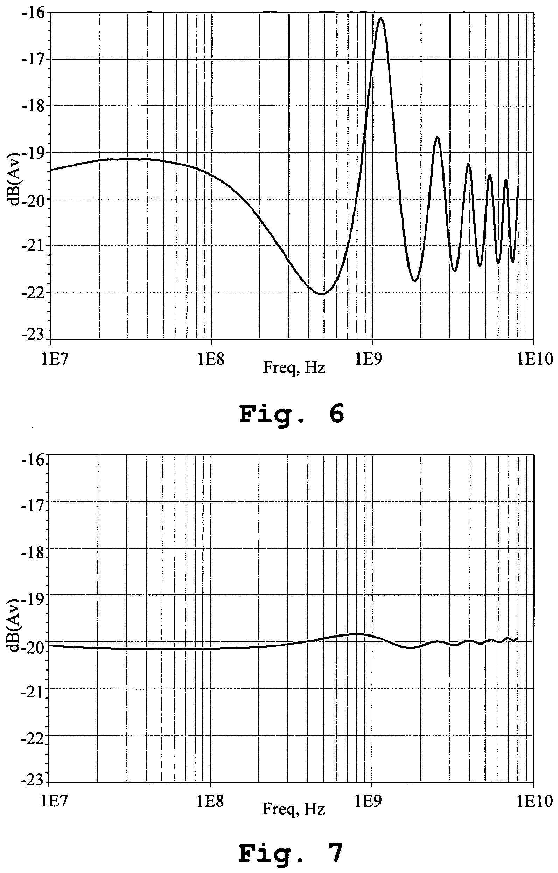

In Fig. 5 wird eine tabellarische Übersicht der Parameter mehrerer verschiedener beispielhafter Tastköpfe gezeigt. Die hier dargestellten Parameter und die Übertragungsfunktionen der zugehörigen Tastköpfe werden anhand der Fig. 6 - 8 näher erläutert. L' und C' sind die Induktivitäts- und Kapazitäts-Beläge des Wellenleiters. Die Widerstände RI_1 - RI_8 sind die auf dem Wellenleiter 45 aufgebrachten Widerstände. Die Widerstände R1 - R8 sind gleichmäßig mit einem Mittenabstand von 10mm über den Wellenleiter 45 angebracht. Vor dem ersten und nach dem letzten Widerstand R1 - R8 erstrecken sich je 5mm Wellenleiter. Damit ergibt sich eine Gesamtlänge des Wellenleiters 45 von 80mm. Es wird auch deutlich, wie sich die Werte R1, R2, R4, R5 und C1 gegenüber einer ungedämpften Koaxialleitung ändern.

Fig. 6 zeigt eine Übertragungsfunktion des ersten beispielhaften Wellenleiters aus Fig. 1. Die hier gezeigte Übertragungsfunktion entspricht einem Tastkopf mit einem ungedämpften Koaxialleiter als Wellenleiter. Die Parameter dieses Tastkopfes sind in Fig. 5 in Spalte (a) gezeigt. Man erkennt deutlich eine starke Welligkeit durch den nicht reflexionsfrei abgeschlossenen Wellenleiter. Durch eine Erhöhung der Kapazitäten 11, 19 (C1, C2) wäre diese Welligkeit zwar zu reduzieren, es ergäbe sich aber eine hohe Eingangskapazität, die für aktive Tastköpfe unerwünscht ist und den Vergleich zu den folgenden Maßnahmen verfälscht.

Hinzu kommen die prinzipiellen Nachteile eines koaxialen Wellenleiters. Diese sind nicht in gängiger, planarer Leiterplattentechnologie auszuführen. Es können also keine Bauelemente bestückt werden. Der Übergang auf planare Technologie erfolgt über Stecker, die mehr oder minder große Störstellen darstellen. Der Wellenwiderstand ist nicht frei wählbar und kann im Allgemeinen nicht viel größer als 100 Ohm sein. Will man Verbinder verwenden, ist man meist auf 50 Ohm beschränkt. Die Anordnung samt Stecker verbraucht viel Platz, ist teuer und die Kabel samt Schirmgeflecht haben ein hohes Gewicht. Bei differenzieller Übertragung betragen die Wellenwiderstände meist 100 Ohm für den differenziellen Modus und 25 Ohm für den Gleichtaktmodus. Auch hier gibt es kaum Freiheitsgrade. Längentoleranzen der beiden Einzelkabel führen zu Konversion und damit schlechter Gleichtaktunterdrückung.

Führt man den Wellenleiter aus Fig. 1 und Fig. 2 statt als Koaxialkabel als Dünnschichtschaltung auf flexiblem Grundmaterial, wie z.B. in Fig. 3 dargestellt, aus, so können die oben genannten Probleme elegant umgangen werden. Durch sehr dünne Schichten im nm-Bereich können beliebig große Widerstandsbeläge erzeugt werden. Durch laterale Strukturierung können sogar konzentrierte Widerstände erzeugt werden. In Fig. 7 wird die Übertragungsfunktion eines Tastkopfes mit einem solchen Wellenleiter gezeigt. Die Dimensionierung entspricht dabei der Spalte (c) aus Fig. 5. Ein Widerstand von 28 Ohm auf jedem Zentimeter der Leitung dämpft die Welligkeit. Dadurch ist die Welligkeit (hier ca. 0,1 dB) viel geringer als bei der koaxialen Variante (ca. 4 dB). Dadurch, dass die Widerstände einzeln getrimmt werden können, ist die Toleranz des Widerstandsbelags vernachlässigbar. Damit ist auch die Spannungsübertragungsfunktion sehr robust gegen Produktionstoleranzen.

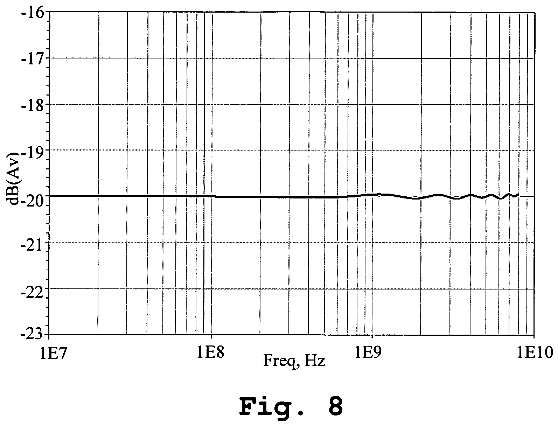

Geht man noch einen Schritt weiter, sind bei der planaren Schaltung sogar variable Widerstände realisierbar. Fig. 8 zeigt die Übertragungsfunktion derselben Leitung mit variablen Widerständen auf jedem Zentimeter der Leitung, entsprechend der Dimensionierung aus Spalte (d) in Fig. 5. In dieser Ausführung ist die verbleibende Welligkeit der Übertragungsfunktion vernachlässigbar klein (0,04dB). Um die optimale Dimensionierung zu finden, ist die Verwendung eines Optimierungsalgorithmus nützlich. Dieser ist in der Lage, eine optimale Widerstandsverteilung für dieses hochdimensionale Problem zu finden. Es ergeben sich so glättere Frequenzgänge, als dies durch anschauliche Dimensionierungsvorschriften möglich wäre.

Hinzu kommen die prinzipiellen Vorteile einer planare Leitung. Eine solche Leitung ist komplett in planarer Technologie herzustellen. Sie kann ohne Störstellen an das Signal erzeugende Bauelemente angeschlossen werden. Der Wellenwiderstand ist nahezu beliebig frei einstellbar. Unnötig große Kapazitäten durch eine Schirmmasse entfallen. Die Anordnung auf flexibler Leiterplatte ist extrem leicht, preisgünstig, Platz sparend und kann nahezu beliebig mechanisch verlegt werden. Im differenziellen Fall gibt es keine Längentoleranzen der Einzelleiter und damit verbundene Modenkonversion.

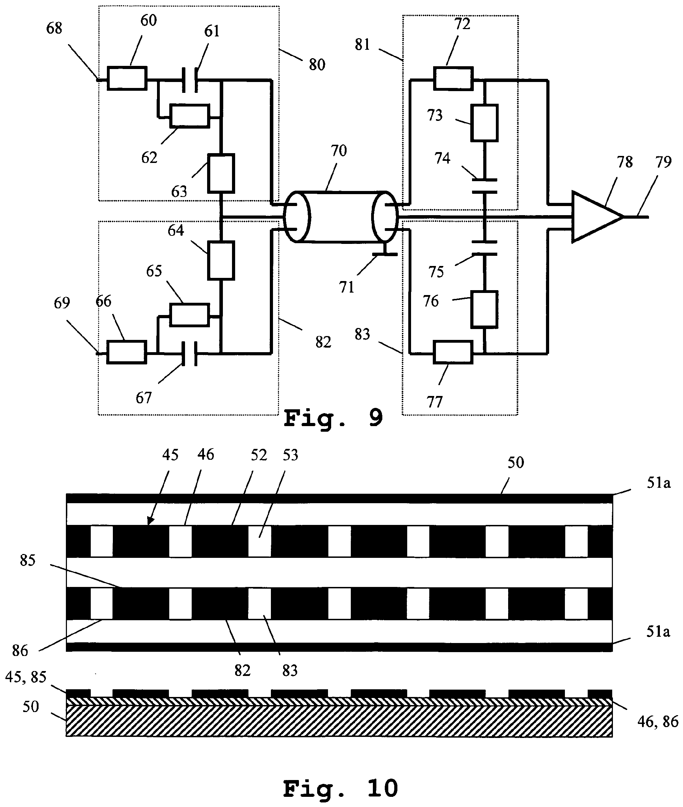

In Fig. 9 wird ein Blockdiagramm eines sechsten Ausführungsbeispiels des erfindungsgemäßen Tastkopfes dargestellt. Hier wird der erfindungsgemäße Tastkopf für differentielle Leitungen gezeigt. Die Widerstände 60, 62, 63 bilden mit der Kapazität 61 ein Teilerelement 80 für den ersten Tastspitzenanschluss 68. Symmetrisch für den zweiten Tastspitzenanschluss 69 bilden die Widerstände 64, 65 und 66 mit der Kapazität 67 ein Teilerelement 82. Der differentielle Wellenleiter 70, welcher über eine Schirmung mit einem Masseanschluss 71 verfügt, leitet die Signale an weitere symmetrische Teilerelemente 81, 83 weiter. Diese werden durch die Widerstände 72, 73, 76, 77 und die Kapazitäten 74 und 75 gebildet. Abschließend wird das differentielle Signal von dem Pufferverstärker 78 verstärkt und über den Anschluss 79 an das Messgerät geleitet.

Fig. 10 zeigt den Aufbau des in Fig. 10 eingesetzten erfindungsgemäßen Wellenleiters. Auf dem Substrat 50 sind zwei Streifen 46, 86 einer hochohmig leitfähigen Schicht aufgebracht. Auf diesen Streifen 46, 86 sind Metallisierungen 52, 82 der Streifenleiter 45, 85 aufgebracht. Durch die Aussparungen 53, 83 in den Metallisierungen 52, 82 sind diskrete ohmsche Widerstände realisiert. In der Zeichnung sind der besseren Übersichtlichkeit halber die Längen der Aussparungen gegenüber den Längen der Streifenleiter stark vergrößert dargestellt. Die Aussparungen sind im Ausführungsbeispiel über die Länge des Streifenleiters gleichmäßig verteilt und verfügen über identische Länge. Die Aussparungen sind bei beiden Streifenleitern 45, 85 auf gleicher Position und mit gleicher Länge ausgeführt, um Symmetrie der Signalübertragung zu erzielen. Das Substrat 50 verfügt zusätzlich vorderseitig über eine Metallisierung 51a, die als Masseleiter dient. Diese ist für die Funktion im differentiellen Betrieb nicht notwendig und kann auch entfallen.

Die Erfindung ist nicht auf das dargestellte Ausführungsbeispiel beschränkt. Wie bereits erwähnt, können unterschiedliche Signale übertragen werden. Eine Beschränkung auf differentielle Signale ist nicht gegeben. Auch ist ein Einsatz von Wellenleitern mit einer größeren Anzahl an Leitern denkbar. Eine große Vielfalt an Substratmaterialien kann darüber hinaus eingesetzt werden. Alle vorstehend beschriebenen Merkmale oder in den Figuren gezeigten Merkmale sind im Rahmen der Erfindung beliebig miteinander kombinierbar. Insbesondere lassen sich die in den Figuren 4 und 11 dargestellten Ausführungsbeispiele miteinander kombinieren.

## Patentansprüche

1. Tastkopf mit zumindest einem Wellenleiter (15, 70), wobei der zumindest eine Wellenleiter (15, 70) zumindest einen Streifenleiter (45, 85) beinhaltet, und
wobei der zumindest eine Streifenleiter (45, 85) mehrere konzentrierte ohmsche Widerstände (35) beinhaltet,
**dadurch gekennzeichnet,**
**dass** die mehreren konzentrierten ohmschen Widerstände in festgelegten Abständen über die Länge des Streifenleiters (45, 85) verteilt sind, und
**dass** die mehreren konzentrierten ohmschen Widerstände durch Strukturierung des Streifenleiters (45, 85) gebildet sind.

2. Tastkopf nach Anspruch 1,
**dadurch gekennzeichnet,**
**dass** die Größe und Verteilung der konzentrierten ohmschen Widerstände auf dem zumindest einen Streifenleiter (45, 85) die Übertragungsfunktion des Wellenleiters (15, 70) einstellt.

3. Tastkopf nach Anspruch 1 oder 2,
**dadurch gekennzeichnet,**
**dass** der Tastkopf zumindest ein passives Teilerelement (23, 24, 80, 81, 82, 83) beinhaltet.

4. Tastkopf nach einem der Ansprüche 1 bis 3,
**dadurch gekennzeichnet,**
**dass** der Tastkopf zumindest einen Pufferverstärker (21, 78) beinhaltet.

5. Tastkopf nach einem der Ansprüche 1 bis 4,
**dadurch gekennzeichnet,**
**dass** der zumindest eine Streifenleiter (45, 85) als eine metallisierte Schicht auf einem Substrat (50) ausgebildet ist.

6. Tastkopf nach Anspruch 5,
**dadurch gekennzeichnet,**
**dass** zwischen dem Substrat (50) und der metallisierten Schicht (52) eine Widerstandsschicht (46, 86) aufgebracht ist, und dass die Widerstandsschicht (46, 86) einen höheren ohmschen Widerstand aufweist als die metallisierte Schicht (52).

7. Tastkopf nach Anspruch 5 oder 6,
**dadurch gekennzeichnet,**
**dass** die mehreren konzentrierten ohmschen Widerstände durch Aussparungen der metallisierten Schicht (52) gebildet sind.

8. Tastkopf nach Anspruch 7,
**dadurch gekennzeichnet,**
**dass** die Aussparungen der metallisierten Schicht über die gesamte Breite des Streifenleiters (45, 85) ausgebildet sind, und
**dass** die Längen der Aussparungen der metallisierten Schicht die Größe der ohmschen Widerstände bestimmen.

9. Tastkopf nach Anspruch 7 oder 8,
**dadurch gekennzeichnet,**
**dass** die Aussparungen der metallisierten Schicht durch einen Ätzvorgang erzeugt sind.

10. Tastkopf nach einem der Ansprüche 5 bis 9,
**dadurch gekennzeichnet,**
**dass** die metallisierte Schicht aus Gold oder aus Kupfer besteht.

11. Tastkopf nach einem der Ansprüche 5 bis 10,
**dadurch gekennzeichnet,**
**dass** die Widerstandsschicht (46, 86) aus einer NickelChrom-Legierung besteht.

12. Tastkopf nach einem der Ansprüche 5 bis 11,
**dadurch gekennzeichnet,**
**dass** auf der Rückseite des Substrats (50) eine metallisierte Lage (51) als Masse aufgebracht ist.

13. Tastkopf nach einem der Ansprüche 5 bis 12,
**dadurch gekennzeichnet,**
**dass** auf der Vorderseite des Substrats (50) metallisierte Streifen (51a) als Masse aufgebracht sind.

14. Tastkopf nach einem der Ansprüche 1 bis 13,
**dadurch gekennzeichnet,**
**dass** der Tastkopf zumindest zwei Streifenleiter (45, 85) beinhaltet,
**dass** jeder der zumindest zwei Streifenleiter (45, 85) mehrere konzentrierte ohmsche Widerstände beinhaltet, dass die konzentrierten ohmschen Widerstände symmetrisch auf den beiden Streifenleitern (45, 85) angeordnet sind, und dass die jeweils symmetrischen ohmschen Widerstände auf den beiden Streifenleitern (45, 85) die gleiche Größe haben.

15. Tastkopf nach einem der Ansprüche 1 bis 14,
**dadurch gekennzeichnet,**
**dass** der Tastkopf zumindest zwei Streifenleiter (45, 85) beinhaltet, und
**dass** die zumindest zwei Streifenleiter (45, 85) zumindest eine Überkreuzung aufweisen.

16. Tastkopf nach einem der Ansprüche 1 bis 15,
**dadurch gekennzeichnet,**
**dass** die mehreren konzentrierten ohmschen Widerstände gleichmäßig in konstanten Abständen über die Länge des zumindest einen Streifenleiters (45, 85) verteilt sind.

17. Tastkopf nach einem der Ansprüche 1 bis 16,
**dadurch gekennzeichnet,**
**dass** die mehreren konzentrierten ohmschen Widerstände ungleichmäßig über die Länge des zumindest einen Streifenleiters (45, 85) verteilt sind.

18. Tastkopf nach einem der Ansprüche 1 bis 17,
**dadurch gekennzeichnet,**
**dass** die mehreren konzentrierten ohmschen Widerstände dieselbe Größe aufweisen.

19. Tastkopf nach einem der Ansprüche 1 bis 17,
**dadurch gekennzeichnet,**
**dass** die mehreren konzentrierten ohmschen Widerstände unterschiedliche Größen aufweisen.

20. Tastkopf nach einem der Ansprüche 1 bis 19,
**dadurch gekennzeichnet,**
**dass** der Widerstandswert der mehreren konzentrierten ohmschem Widerstände im Bereich von 1 Ohm bis 100 Ohm, bevorzugt im Bereich von 10 Ohm bis 50 Ohm, besonders bevorzugt im Bereich von 25 Ohm bis 35 Ohm liegt.

21. Tastkopf nach einem der Ansprüche 1 bis 20,
**dadurch gekennzeichnet,**
**dass** der Abstand auf dem Streifenleiter zwischen den mehreren konzentrierten ohmschen Widerständen unterhalb von 20 mm, bevorzugt unterhalb von 10 mm, besonders bevorzugt unterhalb von 5 mm liegt.

## Claims

1. Probe with at least one waveguide (15, 70),
wherein the at least one waveguide (15, 70) comprises at least one strip conductor (45, 85), and
wherein the at least one strip conductor (45, 85) comprises a plurality of concentrated ohmic resistors (35),
**characterised in that**
the plurality of concentrated ohmic resistors are distributed at defined intervals over the length of the strip conductor (45, 85), and
**in that** the plurality of concentrated ohmic resistors are formed by structuring of the strip conductor (45, 85).

2. Probe according to claim 1,
**characterised in that**
the size and distribution of the concentrated ohmic resistors on the at least one strip conductor (45, 85) sets the transfer function of the waveguide (15, 70).

3. Probe according to claim 1 or 2,
**characterised in that**
the probe comprises at least one passive divider element (23, 24, 80, 81, 82, 83).

4. Probe according to one of claims 1 to 3,
**characterised in that**
the probe comprises at least one buffer amplifier (21, 78) .

5. Probe according to one of claims 1 to 4,
**characterised in that**
the at least one strip conductor (45, 85) is embodied in the form of a metallised layer on a substrate (50).

6. Probe according to claim 5,
**characterised in that**
a resistive layer (46, 86) is applied between the substrate (50) and the metallised layer (52), and **in that** the resistive layer (46, 86) has a higher ohmic resistance than the metallised layer (52).

7. Probe according to claim 5 or 6,
**characterised in that**
the plurality of concentrated ohmic resistors are formed by openings in the metallised layer (52).

8. Probe according to claim 7,
**characterised in that**
the openings in the metallised layer are formed over the entire width of the strip conductor (45, 85), and
**in that** the lengths of the openings in the metallised layer determine the size of the ohmic resistors.

9. Probe according to claim 7 or 8,
**characterised in that**
the openings in the metallised layer are produced by an etching operation.

10. Probe according to one of claims 5 to 9,
**characterised in that**
the metallised layer is composed of gold or of copper.

11. Probe according to one of claims 5 to 10,
**characterised in that**
the resistive layer (46, 86) is composed of a nickel-chromium alloy.

12. Probe according to one of claims 5 to 11,
**characterised in that**
a metallised layer (51) is applied on the rear side of the substrate (50) as ground.

13. Probe according to one of claims 5 to 12,
**characterised in that**
metallised strips (51a) are applied on the front side of the substrate (50) as ground.

14. Probe according to one of claims 1 to 13,
**characterised in that**
the probe comprises at least two strip conductors (45, 85),
**in that** each of the at least two strip conductors (45, 85) comprises a plurality of concentrated ohmic resistors,
**in that** the concentrated ohmic resistors are arranged symmetrically on the two strip conductors (45, 85), and **in that** each of the symmetrical ohmic resistors on the two strip conductors (45, 85) is the same size.

15. Probe according to one of claims 1 to 14,
**characterised in that**
the probe comprises at least two strip conductors (45, 85), and
**in that** the at least two strip conductors (45, 85) have at least one crossover.

16. Probe according to one of claims 1 to 15,
**characterised in that**
the plurality of concentrated ohmic resistors are distributed evenly at constant intervals over the length of the at least one strip conductor (45, 85).

17. Probe according to one of claims 1 to 16,
**characterised in that**
the plurality of concentrated ohmic resistors are distributed unevenly over the length of the at least one strip conductor (45, 85).

18. Probe according to one of claims 1 to 17,
**characterised in that**
the plurality of concentrated ohmic resistors are the same size.

19. Probe according to one of claims 1 to 17,
**characterised in that**
the plurality of concentrated ohmic resistors are different sizes.

20. Probe according to one of claims 1 to 19,
**characterised in that**
the resistance value of the plurality of concentrated ohmic resistors lies in the range of from 1 Ohm to 100 Ohms, preferably in the range of from 10 Ohms to 50 Ohms, particularly preferably in the range of from 25 Ohms to 35 Ohms.

21. Probe according to one of claims 1 to 20,
**characterised in that**
the interval on the strip conductor between the plurality of concentrated ohmic resistors lies below 20 mm, preferably below 10 mm, particularly preferably below 5 mm.

## Revendications

1. Tête de sonde avec au moins un guide d'ondes (15, 70), où le au moins un guide d'ondes (15, 70) contient au moins un guide d'ondes à ruban (45, 85), et où le au moins un guide d'ondes à ruban (45, 85) contient plusieurs résistances ohmiques concentrées (35),
**caractérisée en ce que** les plusieurs résistances ohmiques concentrées sont réparties à des distances fixées sur la longueur du guide d'ondes à ruban (45, 85), et
**en ce que** les plusieurs résistances ohmiques concentrées sont formées par structuration du guide d'ondes à ruban (45, 85).

2. Tête de sonde selon la revendication 1, **caractérisée en ce que** la taille et la répartition des résistances ohmiques concentrées sur le au moins un guide d'ondes à ruban (45, 85) ajustent la fonction de transmission du guide d'ondes (15, 70).

3. Tête de sonde selon la revendication 1 ou 2, **caractérisée en ce que** la tête de sonde contient au moins un élément diviseur passif (23, 24, 80, 81, 82, 83).

4. Tête de sonde selon l'une des revendications 1 à 3, **caractérisée en ce que** la tête de sonde contient au moins un amplificateur tampon (21, 78).

5. Tête de sonde selon l'une des revendications 1 à 4, **caractérisée en ce que** le au moins un guide d'ondes à ruban (45, 85) est agencé sous forme d'une couche métallisée sur un substrat (50).

6. Tête de sonde selon la revendication 5, **caractérisée en ce que**, entre le substrat (50) et la couche métallisée (52), une couche de résistance (46, 86) est appliquée, et **en ce que** la couche de résistance (46, 86) présente une plus grande résistance ohmique que la couche métallisée (52).

7. Tête de sonde selon la revendication 5 ou 6, **caractérisée en ce que** les plusieurs résistances ohmiques concentrées sont formées par des évidements de la couche métallisée (52).

8. Tête de sonde selon la revendication 7, **caractérisée en ce que** les évidements de la couche métallisée sont formés sur toute la largeur du guide d'ondes à ruban (45, 85), et **en ce que** les longueurs des évidements de la couche métallisée déterminent la taille des résistances ohmiques.

9. Tête de sonde selon la revendication 7 ou 8, **caractérisée en ce que** les évidements de la couche métallisée sont produits par un processus de gravure.

10. Tête de sonde selon l'une des revendications 5 à 9, **caractérisée en ce que** la couche métallisée consiste en or ou en cuivre.

11. Tête de sonde selon l'une des revendications 5 à 10, **caractérisée en ce que** la couche de résistance (46, 86) consiste en un alliage nickel-chrome.

12. Tête de sonde selon l'une des revendications 5 à 11, **caractérisée en ce qu'**une strate métallisée (51) est appliquée comme masse sur le côté postérieur du substrat (50).

13. Tête de sonde selon l'une des revendications 5 à 12, **caractérisée en ce que** des rubans métallisés (51a) sont appliqués comme masse sur le côté antérieur du substrat (50).

14. Tête de sonde selon l'une des revendications 1 à 13, **caractérisée en ce que** la tête de sonde contient au moins deux guides d'ondes à ruban (45, 85), **en ce que** chacun des au moins deux guides d'ondes à ruban (45, 85) contient plusieurs résistances ohmiques concentrées, **en ce que** les résistances ohmiques concentrées sont disposées de manière symétrique sur les deux guides d'ondes à ruban (45, 85), et **en ce que** les différentes résistances ohmiques concentrées symétriques ont la même taille sur les deux guides d'ondes à ruban (45, 85).

15. Tête de sonde selon l'une des revendications 1 à 14, **caractérisée en ce que** la tête de sonde contient au moins deux guides d'ondes à ruban (45, 85), et **en ce que** les au moins deux guides d'ondes à ruban (45, 85) présentent au moins un croisement.

16. Tête de sonde selon l'une des revendications 1 à 15, **caractérisée en ce que** les plusieurs résistances ohmiques concentrées sont réparties régulièrement à des distances constantes sur la longueur du au moins un guide d'ondes à ruban (45, 85).

17. Tête de sonde selon l'une des revendications 1 à 16, **caractérisée en ce que** les plusieurs résistances ohmiques concentrées sont réparties irrégulièrement sur la longueur du au moins un guide d'ondes à ruban (45, 85).

18. Tête de sonde selon l'une des revendications 1 à 17, **caractérisée en ce que** les plusieurs résistances ohmiques concentrées présentent la même taille.

19. Tête de sonde selon l'une des revendications 1 à 17, **caractérisée en ce que** les plusieurs résistances ohmiques concentrées présentent des tailles différentes.

20. Tête de sonde selon l'une des revendications 1 à 19, **caractérisée en ce que** la valeur de résistance des plusieurs résistances ohmiques concentrées est située dans le domaine de 1 ohm à 100 ohms, de préférence dans le domaine de 10 ohms à 50 ohms, de manière particulièrement préférée dans le domaine de 25 ohms à 35 ohms.

21. Tête de sonde selon l'une des revendications 1 à 20, **caractérisée en ce que** la distance sur le guide d'ondes à ruban entre les plusieurs résistances ohmiques concentrées est située au-dessous de 20 mm, de préférence au-dessous de 10 mm, de manière particulièrement préférée au-dessous de 5 mm.
